# EUROPEAN PATENT APPLICATION

(11) **EP 1 953 831 A2**
(43) Date of publication of application: **06.08.2008**
(21) Application number: 08001050.7
(22) Date of filing: 21.01.2008
(51) Int. Cl.: H01L 31/075

(54) **Stacked photoelectric conversion device and method of producing the same**

(30) Priority: 23.01.2007 JP 2007012742
(71) Applicant: Sharp Kabushiki Kaisha, Osaka-shi, Osaka 545-8522 (JP)
(72) Inventor: Nasuno, Yoshiyuki, Kashihara-shi Nara 634-0006 (JP); Ishikawa, Yasuaki, Fujiidera-shi Osaka 583-0012 (JP); Nakano, Takanori, Kashiba-shi Nara 639-0223 (JP)
(74) Representative: Müller - Hoffmann & Partner

(57) **Abstract**

A stacked photoelectric conversion device includes a first photoelectric conversion layer, a second photoelectric conversion layer and a third photoelectric conversion layer each having a p-i-n junction and made of a silicon base semiconductor, stacked in this order from a light entrance side, wherein the first and the second photoelectric conversion layers have an i-type amorphous layer made of an amorphous silicon base semiconductor, respectively, and the third photoelectric conversion layer has an i-type microcrystalline layer made of a microcrystalline silicon base semiconductor.

## Description

### BACKGROUND OF THE INVENTION

### 1. Field of the Invention

The present invention relates to a stacked photoelectric conversion device and a method of producing the same, and more particularly to a stacked photoelectric conversion device such as a solar cell, a sensor or the like produced by a plasma CVD method or the like, and a method of producing the same.

### 2. Description of Related Art

In recent years, thin-film photoelectric conversion devices which are formed from gases as a raw material by a plasma CVD method receive attention. Examples of such thin-film photoelectric conversion devices include silicon base thin-film photoelectric conversion devices including a silicon base thin-film, thin-film photoelectric conversion devices including CIS (CuInSe₂) compounds or CIGS (Cu(In,Ga) Se₂) compounds, and the like, and development of these devices are accelerated and their quantity of production is increasingly enlarged. A major feature of these photoelectric conversion devices lies in a fact that these devices have potential that cost reduction and higher performance of the photoelectric conversion device can be simultaneously achieved by stacking a semiconductor layer or a metal electrode film on a low-cost substrate with a large area with a formation apparatus such as a plasma CVD apparatus or a sputtering apparatus, and then separating/connecting photoelectric conversion devices prepared on the same substrate by laser patterning.

One structure of such a thin film photoelectric conversion device is a structure of a stacked photoelectric conversion device making effective use of incident light. The structure of the stacked photoelectric conversion device is a structure for splitting an incident light spectrum and receiving the split light spectrum in a plurality of photoelectric conversion layers, and by stacking a plurality of photoelectric conversion layers which use a semiconductor material having a bandgap suitable for absorbing the respective wavelength bands in decreasing order of bandgap from a light entrance side, it is possible to absorb the short wavelength light in the photoelectric conversion layer having a large bandgap and the long-wavelength light in the photoelectric conversion layer having a small bandgap, respectively. Therefore, sunlight having a wider wavelength band can contribute to the photoelectric conversion compared with a device provided with one photoelectric conversion layer, and therefore it becomes possible to enhance the photoelectric conversion efficiency.

Japanese Unexamined Patent Publication No. HEI 11 (1999)-243218 discloses a stacked photoelectric conversion device having a first p-i-n junction, a second p-i-n junction, and a third p-i-n junction in this order from the the light-entering side, wherein the first p-i-n junction has an i-type layer of amorphous silicon, the second p-i-n junction has an i-type layer of microcrystalline silicon, the third p-i-n junction has an i-type layer of microcrystalline silicon. It is described that by employing such a constitution, it is possible to realize high photoelectric conversion efficiency by effective use of light and reduce impact caused by light degradation of the i-type amorphous silicon, and thus to improve the photoelectric conversion efficiency after light degradation.

As another stacked photoelectric conversion device of three junction type, a stacked photoelectric conversion device (a-SiC/a-SiGe/a-SiGe), in which amorphous silicon-carbon is used as an i-type layer of a first p-i-n junction on the light entrance side, amorphous silicon-germanium is used as an i-type layer of a second p-i-n junction on the light entrance side and amorphous silicon-germanium having a smaller bandgap than the i-type layer of the second p-i-n junction is used as an i-type layer of a third p-i-n junction on the light entrance side, is known.

However, in the stacked photoelectric conversion device disclosed in Japanese Unexamined Patent Publication HEI 11 (1999)-243218, it is considered that preferably, a film thickness of the i-type layer (amorphous silicon layer) of the first p-i-n junction is 500 to 2500 Å, a film thickness of the i-type layer (microcrystalline silicon layer) of the second p-i-n junction is 0.5 µm or more and 1.5 µm or less, and a film thickness of the i-type layer (microcrystalline silicon layer) of the third p-i-n junction is 1.5 µm or more and 3.5 µm or less, and since these film thicknesses are large, there is a problem that a time required to form a film is lengthened and this device is unsuitable for mass production.

The stacked photoelectric conversion device with a structure of a-SiC/a-SiGe/a-SiGe has a problem that it is difficult to form a film having a uniform composition ratio between Si and Ge on a substrate with a large area, and thus it is difficult to enlarge a substrate area.

### SUMMARY OF THE INVENTION

The present invention has been made in view of the above-discussed points and it is an object of the present invention to provide a practical stacked photoelectric conversion device which has good photoelectric conversion efficiency and is suitable for mass production and enlargement of a substrate area, and a method of producing the same.

A stacked photoelectric conversion device of the present invention includes a first photoelectric conversion layer, a second photoelectric conversion layer and a third photoelectric conversion layer, stacked in this order from a light entrance side, each of which has a p-i-n junction and is made of a silicon base semiconductor, and the first and the second photoelectric conversion layers have an i-type amorphous layer made of an amorphous silicon base semiconductor, respectively, and the third photoelectric conversion layer has an i-type microcrystalline layer made of a microcrystalline silicon base semiconductor.

The stacked photoelectric conversion device having such a constitution has high photoelectric conversion efficiency by effective use of incident light, and can realize a highly practical stacked photoelectric conversion device which can realize a practical tact time in mass production and enlargement of a substrate area.
In general, impact of light degradation of the i-type amorphous layer on the photoelectric conversion efficiency becomes larger as the thickness of the i-type amorphous layer increases. Thus assuming that light degradation characteristic per a unit film thickness of the i-type amorphous layer is not varied, the photoelectric conversion efficiency is more largely reduced as the thickness of the i-type amorphous layer increases. But, In accordance with the present invention, by forming two layers of photoelectric conversion devices each having an i-type amorphous layer, the i-type amorphous layer contained in the first photoelectric conversion layer can be relatively thinned, and thereby, the degradation of the i-type amorphous layer contained in the first photoelectric conversion layer can be suppressed.

### BRIEF DESCRIPTION OF THE DRAWINGS

Fig. 1 is a schematic sectional view of a stacked photoelectric conversion device of an embodiment of the present invention,
Fig. 2 is a schematic sectional view of a plasma CVD apparatus used for producing the stacked photoelectric conversion device of the embodiment of the present invention, and
Fig. 3 is a graph showing a relationship between a relative value of long-wavelength sensitivity and a concentration of hydrogen atoms in an i-type amorphous layer of a photoelectric conversion device of an associated experiment of Example 1 of the present invention.

### DESCRIPTION OF THE PREFERRED EMBODIMENTS

A stacked photoelectric conversion device of an embodiment of the present invention includes a first photoelectric conversion layer, a second photoelectric conversion layer and a third photoelectric conversion layer, stacked in this order from a light entrance side, each of which has a p-i-n junction and is made of a silicon base semiconductor, and the first and the second photoelectric conversion layers have an i-type amorphous layer made of an amorphous silicon base semiconductor, respectively, and the third photoelectric conversion layer has an i-type microcrystalline layer made of a microcrystalline silicon base semiconductor.
Hereinafter, various embodiments will be exemplified.

The bandgap of the i-type amorphous layer of the first photoelectric conversion layer may be larger than that of the i-type amorphous layer of the second photoelectric conversion layer. In this case, the i-type layers of the photoelectric conversion layers have a relationship of the i-type amorphous layer of the first photoelectric conversion layer > the i-type amorphous layer of the second photoelectric conversion layer > the i-type microcrystalline layer of the third photoelectric conversion layer in terms of a magnitude of the bandgap of the i-type layer, and light having a wide wavelength band can contribute to the photoelectric conversion.

A concentration of hydrogen atoms in the i-type amorphous layer of the first photoelectric conversion layer may be higher than that in the i-type amorphous layer of the second photoelectric conversion layer. In this case, it is possible to have a relationship of the i-type amorphous layer of the first photoelectric conversion layer > the i-type amorphous layer of the second photoelectric conversion layer in terms of the magnitude of the bandgap of the i-type layer.

In addition, the present invention also provides a method of producing a stacked photoelectric conversion device, including the step of forming a first photoelectric conversion layer, a second photoelectric conversion layer and a third photoelectric conversion layer, stacked in this order from a light entrance side, each of which has a p-i-n junction and is made of a silicon base semiconductor, wherein the first and the second photoelectric conversion layers are formed so as to have an i-type amorphous layer made of an amorphous silicon base semiconductor, respectively, and the third photoelectric conversion layer is formed so as to have an i-type microcrystalline layer made of a microcrystalline silicon base semiconductor.
The stacked photoelectric conversion device produced by such a production method has high photoelectric conversion efficiency by effective use of incident light, and can realize a highly practical stacked photoelectric conversion device which can realize a practical tact time in mass production and enlargement of a substrate area. Therefore, in accordance with the present invention, it becomes possible to produce a stacked photoelectric conversion device of a good quality with high mass-productivity.

The first photoelectric conversion layer and the second photoelectric conversion layer may be formed in such a way that the bandgap of the i-type amorphous layer of the first photoelectric conversion layer is larger than that of the i-type amorphous layer of the second photoelectric conversion layer. In this case, the i-type layers of the photoelectric conversion layers have a relationship of the i-type amorphous layer of the first photoelectric conversion layer > the i-type amorphous layer of the second photoelectric conversion layer > the i-type microcrystalline layer of the third photoelectric conversion layer in terms of the magnitude of the bandgap of the i-type layer, and light having a wider wavelength band can contribute to the photoelectric conversion.

The first, the second and the third photoelectric conversion layers may be formed by a plasma CVD method, in which a process gas including an H₂ gas and an SiH₄ gas is used, and the first and the second photoelectric conversion layers are formed in such a way that a flow rate ratio of the H₂ gas to the SiH₄ gas in forming the i-type amorphous layer of the first photoelectric conversion layer is larger than a flow rate ratio of the H₂ gas to the SiH₄ gas in forming the i-type amorphous layer of the second photoelectric conversion layer. In this case, it is possible to have a relationship of the i-type amorphous layer of the first photoelectric conversion layer > the i-type amorphous layer of the second photoelectric conversion layer in terms of the magnitude of the bandgap of the i-type amorphous layer.

The first, the second and the third photoelectric conversion layers may be formed by the plasma CVD method in which a process gas including an H₂ gas and an SiH₄ gas is used, and the i-type amorphous layer of the first photoelectric conversion layer is formed by continuous discharge plasma and the i-type amorphous layer of the second photoelectric conversion layer is formed by pulse discharge plasma. In this case, it is possible to have a relationship of the i-type amorphous layer of the first photoelectric conversion layer > the i-type amorphous layer of the second photoelectric conversion layer in terms of the magnitude of bandgap of the i-type amorphous layer.

The i-type amorphous layers of the first and the second photoelectric conversion layers may be formed at the same substrate temperature. In this case, a production efficiency becomes high.

The first, the second and the third photoelectric conversion layers may be formed in succession in the same film forming chamber, and comprises the gas replacement step of replacing an inside of the film forming chamber with a replacement gas before forming the first, the second and the third photoelectric conversion layers, forming the i-type amorphous layers of the first and the second photoelectric conversion layers, and forming the i-type microcrystalline layer of the third photoelectric conversion layer, respectively. In this case, equipment cost can be reduced since the first, the second and the third photoelectric conversion layers can be produced by use of the plasma CVD apparatus of a single chamber system. Further, by including the above-mentioned gas replacement step, a concentration of impurities from the preceding step or the outside can be reduced and semiconductor layers of a good quality can be formed.
Various embodiments shown herein can be combined with each other

A stacked photoelectric conversion device (hereinafter, also referred to as a "photoelectric conversion device") of an embodiment of the present invention includes a first photoelectric conversion layer, a second photoelectric conversion layer and a third photoelectric conversion layer, stacked in this order from a light entrance side, each of which has a p-i-n junction and is made of a silicon base semiconductor, and the first and the second photoelectric conversion layers have an i-type amorphous layer made of an amorphous silicon base semiconductor, respectively, and the third photoelectric conversion layer has an i-type microcrystalline layer made of a microcrystalline silicon base semiconductor.

A "silicon base semiconductor" refers to amorphous or microcrystalline silicon, or semiconductors (silicon carbide, silicon-germanium, etc.) formed by doping amorphous or microcrystalline silicon with carbon, germanium or other impurities. "Microcrystalline silicon" refers to silicon in a state of a mixed phase of crystalline silicon having a small grain size (from several tens to 1000 Å) and amorphous silicon. Microcrystalline silicon is formed, for example, when a crystal silicon thin film is prepared at low temperatures using a non-equilibrium method such as a plasma CVD method.

The first photoelectric conversion layer, the second photoelectric conversion layer and the third photoelectric conversion layer may be all made of a silicon base semiconductor of the same specie, or may be made of silicon base semiconductors different in species from each other.
The first photoelectric conversion layer, the second photoelectric conversion layer and the third photoelectric conversion layer respectively have a p-type semiconductor layer, an i-type semiconductor layer and an n-type semiconductor layer, and each semiconductor layer is made of a silicon base semiconductor. The respective semiconductor layers contained in the photoelectric conversion device may be all made of a silicon base semiconductor of the same species, or may be made of silicon base semiconductors different in species from each other. For example, the p-type semiconductor layer and the i-type semiconductor layer may be formed from amorphous silicon and the n-type semiconductor layer may be formed from microcrystalline silicon. Further, for example, the p-type semiconductor layer and the n-type semiconductor layer may be formed from silicon carbide or silicon-germanium and the i-type semiconductor layer may be formed from silicon.
Further, the p-type, the i-type and the n-type semiconductor layers may respectively have a monolayer structure or a multilayer structure. When the semiconductor layers have a multilayer structure, each layer may be made of silicon base semiconductors different in species from each other.

In the following description, a semiconductor layer made of amorphous silicon base semiconductor is referred to as an "amorphous layer", a semiconductor layer made of microcrystalline silicon base semiconductor is referred to as a "microcrystalline layer", and a layer made of amorphous or microcrystalline silicon base semiconductor is referred to as a "semiconductor layer".

Hereinafter, an embodiment of the present invention will be described by use of drawings. The contents shown in the drawings and the following description are exemplification, and the scope of the present invention is not limited to the contents shown in the drawings and the following description. Hereinafter, the present invention will be described taking the photoelectric conversion device of a superstrate structure as an example, but the following description is basically also true for the photoelectric conversion device of a substrate structure.

### 1. Constitution of photoelectric conversion device

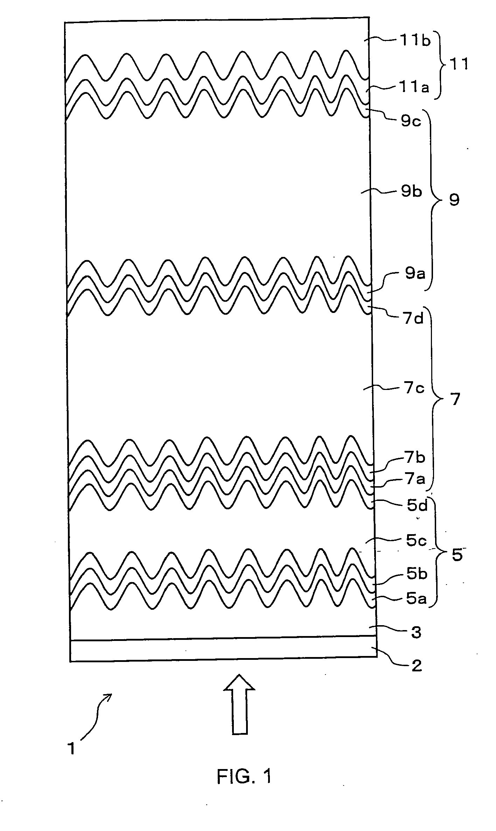

First, a constitution of a photoelectric conversion device of this embodiment will be described by use of Fig. 1. Fig. 1 is a sectional view showing the constitution of the photoelectric conversion device of this embodiment.

As shown in Fig. 1, a photoelectric conversion device 1 of the present embodiment includes a first electrode 3, a first photoelectric conversion layer 5, a second photoelectric conversion layer 7, a third photoelectric conversion layer 9 and a second electrode 11, stacked on a substrate 2. The substrate 2 and the first electrode 3 have a transparent property, and light enters from a side of the substrate 2.

The first photoelectric conversion layer 5 includes a p-type amorphous layer 5a, a buffer layer 5b made of the i-type amorphous layer, an i-type amorphous layer 5c and an n-type semiconductor layer 5d, stacked in this order. The second photoelectric conversion layer 7 includes a p-type amorphous layer 7a, a buffer layer 7b made of the i-type amorphous layer, an i-type amorphous layer 7c and an n-type semiconductor layer 7d, stacked in this order. The third photoelectric conversion layer 9 includes a p-type microcrystalline layer 9a, an i-type microcrystalline layer 9b and an n-type microcrystalline layer 9c, stacked in this order. The buffer layers 5b and 7b can also be omitted. The second electrode 11 includes a transparent conductive film 11a and a metal film 11b, stacked in this order.
The p-type semiconductor layer is doped with p-type impurity atoms such as boron, aluminum, or the like, and the n-type semiconductor layer is doped with n-type impurity atoms such as phosphorus, or the like. The i-type semiconductor layer may be a semiconductor layer which is entirely non-doped, or may be a weak p-type or a weak n-type semiconductor layer including a trace of impurities and having an adequate photoelectric conversion function.

The bandgap of the i-type amorphous layer 5c of the first photoelectric conversion layer 5 is larger than that of the i-type amorphous layer 7c of the second photoelectric conversion layer 7. Further, the bandgap of the i-type amorphous layer 7c of the second photoelectric conversion layer 7 is larger than that of the i-type microcrystalline layer 9b of the third photoelectric conversion layer 9. Accordingly, the i-type layers of the photoelectric conversion layers have a relationship of the i-type amorphous layer of the first photoelectric conversion layer > the i-type amorphous layer of the second photoelectric conversion layer > the i-type microcrystalline layer of the third photoelectric conversion layer in terms of the magnitude of the bandgap of the i-type layer, and light having a wide wavelength band can contribute to the photoelectric conversion.
In addition, since the bandgap of the i-type amorphous layer becomes large as a concentration of hydrogen atoms increases, the bandgap of the i-type amorphous layer 5c is made larger than the i-type amorphous layer 7c by making the concentration of hydrogen atoms in the i-type amorphous layer 5c higher than the i-type amorphous layer 7c.
In addition, the bandgap of the i-type amorphous layer 5c of the first photoelectric conversion layer 5 may be equal to or smaller than the bandgap of the i-type amorphous layer 7c of the second photoelectric conversion layer 7. Even in this case, the i-type amorphous layer 7c of the second photoelectric conversion layer 7 contributes to an absorption of light the i-type amorphous layer 5c of the first photoelectric conversion layer 5 has failed to absorb.

### 2. Plasma CVD apparatus

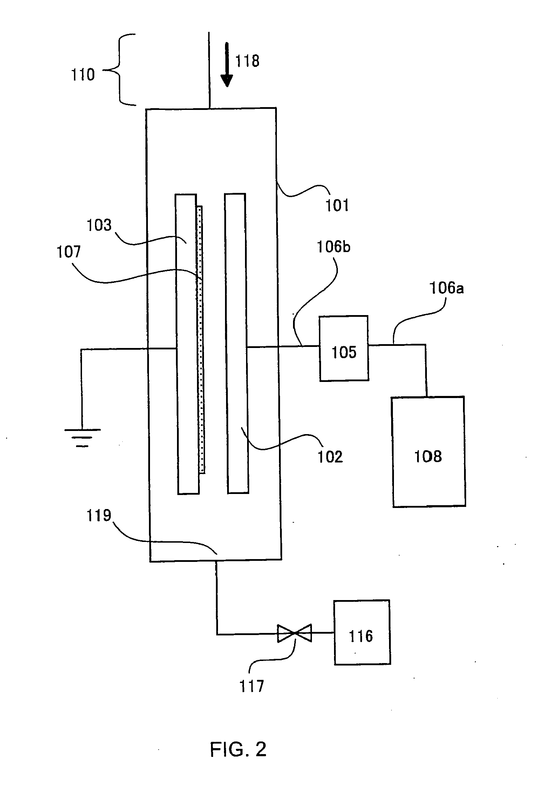

Next, a plasma CVD apparatus for forming a semiconductor layer included in the above photoelectric conversion device will be described by use of Fig. 2. Fig. 2 is a schematic sectional view of the plasma CVD apparatus used for producing a photoelectric conversion device of this embodiment.
A constitution shown in Fig. 2 is an exemplification, and the semiconductor layer may be formed by use of an apparatus of another constitution. Further, the semiconductor layer may be formed by a method other than plasma CVD. Here, the plasma CVD apparatus of a single chamber in which the number of film forming chambers is one will be described as an example, but the following description is also true for a plasma CVD apparatus of a multi-chamber in which the number of film forming chambers is multiple.

As shown in Fig. 2, the plasma CVD apparatus used in this embodiment includes a film forming chamber 101 for forming a semiconductor layer therein, which can be hermetically sealed, a gas intake portion 110 for introducing a replacement gas into the film forming chamber 101, and a gas exhaust portion 116 for evacuating the replacement gas from the film forming chamber 101.
More specifically, the plasma CVD apparatus shown in Fig. 2 has a parallel plate-type electrode configuration in which a cathode electrode 102 and an anode electrode 103 are installed in the film forming chamber 101 capable of being hermetically sealed. A distance between the cathode electrode 102 and the anode electrode 103 is determined depending on desired treatment conditions and it is generally several millimeters to several tens of millimeters. A power supply portion 108 for supplying electric power to the cathode electrode 102 and an impedance matching circuit 105 for matching impedances among the power supply portion 108, the cathode electrode 102 and the anode electrode 103 are installed outside the film forming chamber 101.

The power supply portion 108 is connected to one end of a power introducing line 106a. The other end of the power introducing line 106a is connected to the impedance matching circuit 105. One end of a power introducing line 106b is connected to the impedance matching circuit 105, and the other end of the power introducing line 106b is connected to the cathode electrode 102. The power supply portion 108 may output either of a CW (continuous waveform) alternating current output or a pulse-modulated (on/off control) alternating current output, or may be one capable of switching these outputs to output.
A frequency of the alternating electric power outputted from the power supply portion 108 is generally 13.56 MHz, but it is not limited to this, and frequencies of several kHz to VHF band, and a microwave band may be used.

On the other hand, the anode electrode 103 is electrically grounded, and a substrate 107 is located on the anode electrode 103. The substrate 107 is, for example, the substrate 2 on which the first electrode 3 is formed. The substrate 107 may be placed on the cathode electrode 102, but it is generally located on the anode electrode 103 in order to reduce degradation of a film quality due to ion damage in plasma.

The gas intake portion 110 is provided in the film forming chamber 101. A gas 118 such as a dilution gas, a material gas, a doping gas or the like is introduced from the gas intake portion 110. Examples of the dilution gas include a gas including a hydrogen gas, examples of the material gas include silane base gases, a methane gas, a germane gas and the like. Examples of the doping gas include doping gases of a p-type impurity such as a diborane gas, and the like, and doping gases of an n-type impurity such as a phosphine gas and the like.

Further, the gas exhaust portion 116 and a pressure control valve 117 are connected in series to the film forming chamber 101, and a gas pressure in the film forming chamber 101 is kept approximately constant. It is desirable that the gas pressure is measured at a position away from the gas intake portion 110 and an exhaust outlet 119 in the film forming chamber since measurement of the gas pressure at a position close to the gas intake portion 110 and the exhaust outlet 119 causes errors somewhat. By supplying electric power to the cathode electrode 102 under this condition, it is possible to generate plasma between the cathode electrode 102 and the anode electrode 103 to decompose gases 118, and to form the semiconductor layer on the substrate 107.

The gas exhaust portion 116 may be one capable of evacuating the film forming chamber 101 to reduce the gas pressure in the film forming chamber 101 to a high vacuum of about 1.0×10⁻⁴ Pa, but it may be one having an ability for evacuating gases in the film forming chamber 101 to a pressure of about 0.1 Pa from the viewpoint of a simplification of an apparatus, cost reduction and an increase in throughput. A volume of the film forming chamber 101 becomes larger as a substrate size of the semiconductor device grows in size. When such a film forming chamber 101 is highly evacuated to a vacuum, a high-performance gas exhaust portion 116 is required, and therefore it is not desirable from the viewpoint of the simplification of an apparatus and cost reduction, and it is more desirable to use a simple gas exhaust portion 116 for a low vacuum.

Examples of the simple gas exhaust portion 116 for a low vacuum include a rotary pump, a mechanical booster pump, and a sorption pump, and it is preferable to use these pumps alone or in combination of two or more species.

The film forming chamber 101 of a plasma CVD apparatus used in this embodiment can be sized in about 1 m³. As a typical gas exhaust portion 116, a mechanical booster pump and a rotary pump connected in series can be used.

### 3. Method of producing photoelectric conversion device

Next, a method of producing the above-mentioned photoelectric conversion device 1 will be described. The photoelectric conversion device 1 can be produced by forming the first electrode 3, the first photoelectric conversion layer 5, the second photoelectric conversion layer 7, the third photoelectric conversion layer 9 and the second electrode 11 in order from a light entrance side on the substrate 2.
In this embodiment, three photoelectric conversion layers of the first photoelectric conversion layer 5, the second photoelectric conversion layer 7 and the third photoelectric conversion layer 9 are formed in this order, but for example, three photoelectric conversion layers of the third photoelectric conversion layer 9, the second photoelectric conversion layer 7 and the first photoelectric conversion layer 5 may be formed in this order on the second electrode 11. Further, when a photoelectric conversion device of a substrate structure is formed, it is preferable to form the third photoelectric conversion layer 9, the second photoelectric conversion layer 7 and the first photoelectric conversion layer 5 in this order on a substrate. All structures above are alike in terms of the fact that the first photoelectric conversion layer 5, the second photoelectric conversion layer 7 and the third photoelectric conversion layer 9 are arranged in this order from a light entrance side.

Hereinafter, the method of producing the photoelectric conversion device will be described taking, as an example, the case of forming the semiconductor layer by use of the plasma CVD apparatus of a single chamber in which number of film forming chambers is one, as shown in Fig. 2, but the following description is basically also true for the case of forming the semiconductor layer by use of the plasma CVD apparatus of a multi-chamber. However, in the plasma CVD apparatus of a multi-chamber, a gas replacement step can be omitted since the p-type, the i-type and the n-type semiconductor layers can be formed separately in different film forming chambers.

In the production method of this embodiment, the first photoelectric conversion layer 5, the second photoelectric conversion layer 7 and the third photoelectric conversion layer 9 are formed in the same film forming chamber. To form the photoelectric conversion layers in the same film forming chamber means that the first, the second and the third photoelectric conversion layers 5, 7, and 9 are formed by use of the same electrode or different electrodes in the same film forming chamber, and it is desirable that the first, the second and the third photoelectric conversion layers 5, 7, and 9 are formed by use of the same electrode in the same film forming chamber. Further, it is desirable from the viewpoint of improving a production efficiency that the first, the second and the third photoelectric conversion layers 5, 7, and 9 are successively formed without opening to the air on the way. Furthermore, it is desirable from the viewpoint of improving the production efficiency that substrate temperatures during forming the first, the second and the third photoelectric conversion layers 5, 7, and 9, respectively, are the same.
Hereinafter, the step of forming electrodes or photoelectric conversion layers will be described in detail.

### 3-1. Step of forming first electrode

### First, the first electrode 3 is formed on the substrate 2.

As the substrate 2, a glass substrate and a substrate of resin such as polyimide or the like, which have heat resistance and a transparent property in a plasma CVD forming process, can be used.
As the first electrode 3, a transparent conductive film of SnO₂, ITO, ZnO or the like can be used. These transparent conductive films can be formed by methods such as a CVD method, a sputtering method and a vapor deposition method.

### 3-2. Step of forming first photoelectric conversion layer

Next, the first photoelectric conversion layer 5 is formed on the obtained substrate. As described above, since the first photoelectric conversion layer 5 has the p-type amorphous layer 5a, the buffer layer 5b, the i-type amorphous layer 5c and the n-type semiconductor layer 5d, the respective semiconductor layers are formed in order.
A gas replacement step of replacing the inside of the film forming chamber 101 with a replacement gas is performed to reduce a concentration of impurities in the film forming chamber 101 before forming the p-type amorphous layer 5a (i.e., before forming the first photoelectric conversion layer 5) and before forming the i-type amorphous layer 5c. Since the impurities introduced in the preceding step or the impurities immixed from the outside in carrying a substrate into the film forming chamber 101 remain in the film forming chamber 101, a quality of the semiconductor layer is deteriorated if the semiconductor layer takes in these impurities. Therefore, the concentration of the impurities in the film forming chamber 101 is previously reduced. The gas replacement step is also performed before forming the p-type amorphous layer 7a (i.e., before forming the second photoelectric conversion layer 7), before forming the i-type amorphous layer 7c, before forming the p-type microcrystalline layer 9a (i.e., before forming the third photoelectric conversion layer 9), and before forming the i-type microcrystalline layer 9b. In addition, each gas replacement step may be performed under the same condition, or under different conditions.

In addition, when the plasma CVD apparatus of a multi-chamber is used, the concentration of the impurities in the film forming chamber can be reduced by changing the film forming chamber in place of performing the gas replacement step. In general, the p-type amorphous layer 5a and the buffer layer 5b are formed in a first film forming chamber, the i-type amorphous layer 5c is formed in a second film forming chamber, and the n-type semiconductor layer 5d is formed in a third film forming chamber. Further, the p-type amorphous layer 7a, the buffer layer 7b and the p-type microcrystalline layer 9a are formed in the first film forming chamber, the i-type amorphous layer 7c and the i-type microcrystalline layer 9b are formed in the second film forming chamber, and the n-type semiconductor layer 7d and the n-type microcrystalline layer 9c are formed in the third film forming chamber. The p-type amorphous layer and the buffer layer may be formed in different film forming chambers.
Hereinafter, the step of forming the first photoelectric conversion layer 5 will be described in detail.

### 3-2 (1) Gas replacement step

The substrate 2 on which the first electrode 3 is formed is installed in the film forming chamber 101, and thereafter the gas replacement step of replacing the inside of the film forming chamber 101 with a replacement gas is performed. This gas replacement step is performed to reduce the concentration of the impurities which are immixed from the outside of the film forming chamber 101 in carrying a substrate to be provided with a semiconductor layer in the film forming chamber 101. Further, when the photoelectric conversion device is produced repeatedly, since the first, the second and the third photoelectric conversion layers are formed repeatedly, the n-type microcrystalline layer 9c of the third photoelectric conversion layer 9, previously formed, is deposited on an inner wall and an electrode in the film forming chamber 101. Therefore, it becomes a problem that impurities released from the deposited n-type microcrystalline layer 9c of the third photoelectric conversion layer 9, particularly impurities to determine a conductive type of the n-type microcrystalline layer 9c of the third photoelectric conversion layer 9, are immixed in the p-type amorphous layer 5a of the first photoelectric conversion layer 5. Accordingly, the gas replacement step is performed before forming the p-type amorphous layer 5a to reduce the amount of n-type impurities immixed in the p-type amorphous layer 5a.

Thereby, a semiconductor layer of a good quality can be formed as the p-type amorphous layer 5a of the first photoelectric conversion layer 5. Here, since the p-type amorphous layer 5a generally includes p-type conductive impurities in a concentration of about 1×10²⁰ cm⁻³, good photoelectric conversion characteristics are attained if the concentration of immixed n-type conductive impurities is about 1×10¹⁸ cm⁻³ or less which is 2 orders of magnitude lower than the concentration of the p-type conductive impurities.

The gas replacement step can be performed through an operation cycle in which for example, a hydrogen gas is introduced into the film forming chamber 101 as a replacement gas (step of introducing a replacement gas), the introduction of the hydrogen gas is stopped when the internal pressure of the film forming chamber 101 reaches a prescribed pressure (for example, about 100 Pa to 1000 Pa), and the hydrogen gas is evacuated until the internal pressure of the film forming chamber 101 reaches a prescribed pressure (for example, about 1 Pa to 10 Pa) (evacuation step). This cycle may be repeated more than once.

The time required to perform the above-mentioned one cycle can be several seconds to several tens of seconds. Specifically, the step of introducing a replacement gas can be performed over 1 to 5 seconds and the evacuation step can be performed over 30 to 60 seconds. Even when the steps are performed in such a short time, by repeating this cycle, the concentration of impurities in the film forming chamber can be reduced. Therefore, a production method of the photoelectric conversion device of this embodiment is also practical in applying it to mass production devices.

In this embodiment, it is preferable that an internal pressure of the film forming chamber 101 after introducing a replacement gas and the internal pressure after evacuating the replacement gas are set in advance. In the step of introducing a replacement gas, the evacuation from the film forming chamber 101 is stopped and when the internal pressure of the film forming chamber 101 reaches above the internal pressure after introducing the replacement gas, the introduction of the replacement gas is stopped to terminate the step of introducing a replacement gas. In the evacuation step, the introduction of the replacement gas is stopped and when the internal pressure of the film forming chamber 101 reaches below the internal pressure after evacuating the replacement gas, the evacuation is stopped to terminate the evacuation step.

By increasing the number of repetitions of the cycles, or by decreasing a ratio (M/m) of a pressure M after evacuating the replacement gas to a pressure m after introducing the replacement gas, the concentration of impurities existing in the film forming chamber 101 can be more reduced.

Further, in this embodiment, the present invention is described taking the case where a hydrogen gas is used as a replacement gas as an example, but in another embodiment, any of gases used for forming an i-type layer, such as a silane gas and the like, may be used as a replacement gas. Gases used for forming the i-type layer are used for forming any of a p-type, an i-type and an n-type semiconductor layers. Accordingly, when a gas used for forming the i-type layer is used as a replacement gas, it is preferable since no impurity from this gas is immixed in the semiconductor layer.

Further, in another embodiment, an inert gas or the like which does not have an effect on a film quality of the semiconductor layer may be used as a replacement gas. In particular, a gas having a large atomic weight is apt to remain in the film forming chamber 101 after evacuating the inside of the film forming chamber 101 and is suitable for a replacement gas. Examples of the inert gas include an argon gas, a neon gas, a xenon gas and the like.
Further, the replacement gas may be a mixture gas of any one or more of gases used for forming the i-type layer and one or more inert gases.

### 3-2 (2) Step of forming p-type amorphous layer

Next, the p-type amorphous layer 5a is formed. Hereinafter, the step of forming the p-type amorphous layer 5a will be described.
First, the inside of the film forming chamber 101 can be evacuated to a pressure of 0.001 Pa and a substrate temperature can be set at a temperature of 200°C or lower. Then, the p-type amorphous layer 5a is formed. A mixture gas is introduced into the film forming chamber 101 and an internal pressure of the film forming chamber 101 is kept approximately constant by the pressure control valve 117 installed in an exhaust system. The internal pressure of the film forming chamber 101 is adjusted to, for example, 200 Pa or more and 3000 Pa or less. As the mixture gas introduced into the film forming chamber 101, for example, a gas including a silane gas, a hydrogen gas and a diborane gas can be used. Further, the mixture gas can include gas (for example, methane) containing carbon atoms in order to reduce the amount of light absorption. A flow rate of the hydrogen gas is desirably about several times to several tens of times larger than that of the silane gas.

After the internal pressure of the film forming chamber 101 is stabilized, alternating electric power of several kHz to 80 MHz is inputted to the cathode electrode 102 to generate plasma between the cathode electrode 102 and the anode electrode 103, and the p-type amorphous layer 5a is formed. A power density per unit area of the cathode electrode 102 can be 0.01 W / cm² or more and 0.3 W/cm² or less.

Thus, the p-type amorphous layer 5a having a desired thickness is formed, and then input of alternating electric power is stopped and the film forming chamber 101 is evacuated to a vacuum.

A thickness of the p-type amorphous layer 5a is preferably 2 nm or more, and more preferably 5 nm or more in terms of providing an adequate internal electric field for the i-type amorphous layer 5c. Further, the thickness of the p-type amorphous layer 5a is preferably 50 nm or less, and more preferably 30 nm or less in terms of a necessity for suppressing the amount of light absorption on the light entrance side of an inactive layer.

### 3-2 (3) Step of forming buffer layer

Next, an i-type amorphous layer is formed as the buffer layer 5b. First, a background pressure in the film forming chamber 101 is evacuated to a vacuum of about 0.001 Pa. A substrate temperature can be set at a temperature of 200°C or lower. A mixture gas is introduced into the film forming chamber 101 and an internal pressure of the film forming chamber 101 is kept approximately constant by the pressure control valve 117. The internal pressure of the film forming chamber 101 is adjusted to, for example, 200 Pa or more and 3000 Pa or less. As the mixture gas introduced into the film forming chamber 101, for example, a gas including a silane gas and a hydrogen gas can be used. Further, the mixture gas can include a gas (for example, methane gas) containing carbon atoms in order to reduce the amount of light absorption. Desirably, a flow rate of a hydrogen gas is about several times to several tens of times larger than that of a silane gas.

After the internal pressure of the film forming chamber 101 is stabilized, alternating electric power of several kHz to 80 MHz is inputted to the cathode electrode 102 to generate plasma between the cathode electrode 102 and the anode electrode 103, and an i-type amorphous layer being the buffer layer 5b is formed. A power density per unit area of the cathode electrode 102 can be 0.01 W/cm² or more and 0.3 W/cm² or less.

Thus, the i-type amorphous layer having a desired thickness is formed as the buffer layer 5b, and then input of alternating electric power is stopped and the film forming chamber 101 is evacuated to a vacuum.

By forming the i-type amorphous layer being the buffer layer 5b, a concentration of boron atoms in atmosphere in the film forming chamber 101 is reduced, boron atoms immixed in the i-type amorphous layer 5c to be formed next can be reduced.

A thickness of the i-type amorphous layer being the buffer layer 5b is desirably 2 nm or more in order to inhibit the diffusion of boron atoms from the p-type amorphous layer 5a to the i-type amorphous layer 5c. On the other hand, this thickness is desirably as small as possible in order to suppress the amount of light absorption to increase light reaching the i-type amorphous layer 5c. The thickness of the buffer layer 5b is generally adjusted to 50 nm or less.

### 3-2 (4) Gas replacement step

Next, a gas replacement step is performed by the same method as in "3-2 (1) Gas replacement step".
The p-type amorphous layer 5a, formed in the preceding step, is deposited on an inner wall and an electrode in the film forming chamber 101. Therefore, it becomes a problem that impurities released from the deposited p-type amorphous layer 5a, particularly impurities to determine a conductive type of the p-type amorphous layer 5a, are immixed in the i-type amorphous layer 5c, but by performing the gas replacement step before forming the i-type amorphous layer 5c, the amount of the above-mentioned impurities immixed in the i-type amorphous layer 5c can be reduced. Thereby, a semiconductor layer of a good quality can be formed as the i-type amorphous layer 5c.

### 3-2 (5) Step of forming i-type amorphous layer

Next, the i-type amorphous layer 5c is formed. First, a background pressure in the film forming chamber 101 is evacuated to a vacuum of about 0.001 Pa. A substrate temperature can be set at a temperature of 200°C or lower. Next, a mixture gas is introduced into the film forming chamber 101 and an internal pressure of the film forming chamber 101 is kept approximately constant by the pressure control valve 117. The internal pressure of the film forming chamber 101 is adjusted to, for example, 200 Pa or more and 3000 Pa or less. As the mixture gas introduced into the film forming chamber 101, for example, a gas including a silane gas and a hydrogen gas can be used. A flow rate of the hydrogen gas is preferably about several times to several tens of times larger than that of the silane gas, and more preferably 5 times or more and 30 times or less, and thereby the i-type amorphous layer 5c of a good film quality can be formed.

After the internal pressure of the film forming chamber 101 is stabilized, alternating electric power of several kHz to 80 MHz is inputted to the cathode electrode 102 to generate plasma between the cathode electrode 102 and the anode electrode 103, and an i-type amorphous layer 5c is formed. A power density per unit area of the cathode electrode 102 can be 0.01 W/cm² or more and 0.3 W/cm² or less.

Thus, the i-type amorphous layer 5c having a desired thickness is formed, and then input of alternating electric power is stopped and the film forming chamber 101 is evacuated to a vacuum.

A thickness of the i-type amorphous layer 5c is preferably set at 0.05 µm to 0.25 µm in consideration of the amount of light absorption and the deterioration of the photoelectric conversion characteristics due to light degradation.

### 3-2 (6) Step of forming n-type semiconductor layer

Next, the n-type semiconductor layer 5d is formed. First, a background pressure in the film forming chamber 101 is evacuated to a vacuum of about 0.001 Pa. A substrate temperature can be set at a temperature of 200°C or lower, for example 150°C. Next, a mixture gas is introduced into the film forming chamber 101 and an internal pressure of the film forming chamber 101 is kept approximately constant by the pressure control valve 117. The internal pressure of the film forming chamber 101 is adjusted to, for example, 200 Pa or more and 3000 Pa or less. As the mixture gas introduced into the film forming chamber 101, for example, a gas including a silane gas, a hydrogen gas and a phosphine gas can be used. A flow rate of the hydrogen gas can be 5 times or more and 300 times or less larger than that of the silane gas, and this flow rate of the hydrogen gas is preferably about 30 times to 300 times larger than that of the silane gas in the case of forming the n-type microcrystalline layer.

After the internal pressure of the film forming chamber 101 is stabilized, alternating electric power of several kHz to 80 MHz is inputted to the cathode electrode 102 to generate plasma between the cathode electrode 102 and the anode electrode 103, and an amorphous or microcrystalline n-type semiconductor layer 5d is formed. A power density per unit area of the cathode electrode 102 can be 0.01 W/cm² or more and 0.3 W/cm² or less.

A thickness of the n-type semiconductor layer 5d is preferably 2 nm or more in order to provide an adequate internal electric field for the i-type amorphous layer 5c. On the other hand, the thickness of the n-type semiconductor layer 5d is preferably as small as possible in order to suppress the amount of light absorption in the n-type semiconductor layer 5d being an inactive layer, and it is generally adjusted to 50 nm or less.

Thus, the first photoelectric conversion layer 5 including the i-type amorphous layer 5c can be formed.

### 3-3. Step of forming second photoelectric conversion layer

Next, the second photoelectric conversion layer 7 is formed on the obtained substrate. As described above, since the second photoelectric conversion layer 7 has the p-type amorphous layer 7a, the buffer layer 7b, the i-type amorphous layer 7c and the n-type semiconductor layer 7d, the respective semiconductor layers are formed in order. The second photoelectric conversion layer 7 can be produced by the same formation method as in the first photoelectric conversion layer 5. However, a thickness and formation condition of the i-type amorphous layer 7c are usually different from those of the i-type amorphous layer 5c. Further, the thicknesses and formation conditions of semiconductor layers other than the i-type amorphous layer 7c may be the same, or may be different from each other.
Hereinafter, the step of forming the second photoelectric conversion layer 7 will be described in detail.

### 3-3 (1) Gas replacement step

Next, a gas replacement step is performed by the same method as in "3-2 (1) Gas replacement step". By performing this gas replacement step, it is possible to reduce an amount of impurities released from the n-type semiconductor layer deposited on an inner wall and an electrode in the film forming chamber 101 during forming the n-type semiconductor layer 5d, particularly impurities to determine a conductive type of the n-type semiconductor layer 5d, to be immixed in the p-type amorphous layer 7a. Thereby, a semiconductor layer of a good quality can be formed as the p-type amorphous layer 7a. Here, since the p-type amorphous layer 7a includes p-type conductive impurities in a concentration of about 1×10²⁰ cm⁻³, good photoelectric conversion characteristics are attained if the concentration of immixed n-type conductive impurities is about 1×10¹⁸ cm⁻³ or less which is 2 orders of magnitude lower than the concentration of the p-type conductive impurities.

### 3-3 (2) Step of forming p-type amorphous layer

Next, the p-type amorphous layer 7a is formed by the same method as in the p-type amorphous layer 5a of the first photoelectric conversion layer 5.

### 3-3 (3) Step of forming buffer layer

Next, the buffer layer 7b is formed by the same method as in the buffer layer 5b of the first photoelectric conversion layer 5.

### 3-3 (4) Gas replacement step

Next, a gas replacement step is performed by the same method as in "3-2 (1) Gas replacement step". In this gas replacement step, an effect identical or similar to that in the gas replacement step performed before forming the i-type amorphous layer 5c of the first photoelectric conversion layer 5 can be attained.

### 3-3 (5) Step of forming i-type amorphous layer

Next, the i-type amorphous layer 7c is formed.

A thickness of the i-type amorphous layer 7c is preferably set at 0.1 µm to 0.7 µm in consideration of the amount of light absorption and the deterioration of the photoelectric conversion characteristics due to light degradation.

Further, it is desirable that the bandgap of the i-type amorphous layer 7c of the second photoelectric conversion layer 7 is smaller than the bandgap of the i-type amorphous layer 5c of the first photoelectric conversion layer 5. The reason for this is that by forming such a bandgap, light of wavelength band which the first photoelectric conversion layer 5 cannot absorb can be absorbed in the second photoelectric conversion layer 7 and incident light can be exploited effectively.

In order to lessen the bandgap of the i-type amorphous layer 7c, a substrate temperature during forming a film can be set at elevated temperatures. By increasing the substrate temperature, a concentration of hydrogen atoms contained in the film can be reduced and an i-type amorphous layer 7c having a small bandgap can be formed. That is, it is only necessary to use a substrate temperature during forming the i-type amorphous layer 7c of the second photoelectric conversion layer 7 higher than a substrate temperature during forming the i-type amorphous layer 5c of the first photoelectric conversion layer 5. Thereby, it is possible to make a concentration of hydrogen atoms in the i-type amorphous layer 5c of the first photoelectric conversion layer 5 higher than that in the i-type amorphous layer 7c of the second photoelectric conversion layer 7 and to produce a stacked photoelectric conversion device in which the bandgap of the i-type amorphous layer 5c of the first photoelectric conversion layer 5 is larger than the bandgap of the i-type amorphous layer 7c of the second photoelectric conversion layer 7.

Further, by decreasing a flow rate ratio of a hydrogen gas to a silane gas of a mixture gas introduced into the film forming chamber 101 in forming the i-type amorphous layer 7c, a concentration of hydrogen atoms contained in the i-type amorphous layer 7c can be reduced and the i-type amorphous layer 7c having a small bandgap can be formed. That is, it is only necessary to use the flow rate ratio of the hydrogen gas to the silane gas of the mixture gas during forming the i-type amorphous layer 7c of the second photoelectric conversion layer 7 smaller than that during forming the i-type amorphous layer 5c of the first photoelectric conversion layer 5. Thereby, it is possible to make a concentration of hydrogen atoms in the i-type amorphous layer 5c of the first photoelectric conversion layer 5 higher than that in the i-type amorphous layer 7c of the second photoelectric conversion layer 7 and to produce a stacked photoelectric conversion device in which the bandgap of the i-type amorphous layer 5c of the first photoelectric conversion layer 5 is larger than the bandgap of the i-type amorphous layer 7c of the second photoelectric conversion layer 7.

Furthermore, it is also possible to adjust the bandgap of the i-type amorphous layer by selecting either the case of forming the i-type amorphous layer by continuous discharge plasma or the case of forming the i-type amorphous layer by pulse discharge plasma. When the i-type amorphous layer is formed by continuous discharge plasma, a concentration of hydrogen atoms contained into the i-type amorphous layer to be formed can be higher than that in forming the i-type amorphous layer by pulse discharge plasma.
Accordingly, it is possible to produce a stacked photoelectric conversion device in which the bandgap of the i-type amorphous layer 5c of the first photoelectric conversion layer 5 is larger than the bandgap of the i-type amorphous layer 7c of the second photoelectric conversion layer 7 by switching supply electric power for generating plasma so that the i-type amorphous layer 5c of the first photoelectric conversion layer 5 can be formed by continuous discharge plasma and the i-type amorphous layer 7c of the second photoelectric conversion layer 7 can be formed by pulse discharge plasma.

The above-mentioned setting of the substrate temperatures during forming the i-type amorphous layer 5c of the first photoelectric conversion layer 5 and the i-type amorphous layer 7c of the second photoelectric conversion layer 7, the above-mentioned setting of the flow rate ratio of the hydrogen gas to the silane gas and the above-mentioned setting of the switching between the continuous discharge plasma and the pulse discharge plasma may be set separately, or the respective setting may be used in combination. Particularly when the substrate temperatures during forming the i-type amorphous layer 5c of the first photoelectric conversion layer 5 and the i-type amorphous layer 7c of the second photoelectric conversion layer 7 are the same, concurrent use of the setting of the flow rate ratio of the hydrogen gas to the silane gas and the switching between the continuous discharge plasma and the pulse discharge plasma is desirable since the concentrations of hydrogen atoms contained in the i-type amorphous layer can be changed by a large amount.

### 3-3 (6) Step of forming n-type semiconductor layer

Next, the n-type semiconductor layer 7d is formed by the same method as in the n-type semiconductor layer 5d of the first photoelectric conversion layer 5.

### 3-4. Step of forming third photoelectric conversion layer

Next, the third photoelectric conversion layer 9 is formed on the obtained substrate. As described above, since the third photoelectric conversion layer 9 has the p-type microcrystalline layer 9a, the i-type microcrystalline layer 9b and the n-type microcrystalline layer 9c, the respective semiconductor layers are formed in order.
Hereinafter, the step of forming the third photoelectric conversion layer 9 will be described in detail.

### 3-4 (1) Gas replacement step

First, a gas replacement step is performed by the same method as in "3-2 (1) Gas replacement step". This gas replacement step has an effect identical or similar to that in the gas replacement step performed before forming the second photoelectric conversion layer 7.

### 3-4 (2) Step of forming p-type microcrystalline layer

Next, the p-type microcrystalline layer 9a is formed on the second photoelectric conversion layer 7. The p-type microcrystalline layer 9a can be formed, for example, in the following formation conditions. The substrate temperature is desirably set at a temperature of 200°C or lower. The internal pressure of the film forming chamber 101 during forming the layer is desirably 240 Pa or more and 3600 Pa or less. Further, desirably, the power density per unit area of the cathode electrode 102 is set at 0.01 W/cm² or more and 0.5 W / cm2 or less.

As a mixture gas introduced into the film forming chamber 101, for example, a gas including a silane gas, a hydrogen gas and a diborane gas can be used. A flow rate of the hydrogen gas is desirably about several tens of times to several hundreds of times larger than that of the silane gas, and more desirably about 30 times to 300 times.

A thickness of the p-type microcrystalline layer 9a is preferably 2 nm or more in order to provide an adequate internal electric field for the i-type microcrystalline layer 9b. On the other hand, the thickness of the p-type microcrystalline layer 9a is desirably as small as possible in order to suppress the amount of light absorption in the p-type microcrystalline layer 9a being an inactive layer to increase light reaching the i-type microcrystalline layer 9b, and it is generally adjusted to 50 nm or less.

### 3-4 (3) Gas replacement step

Next, a gas replacement step is performed by the same method as in "3-2 (1) Gas replacement step". This gas replacement step has an effect identical or similar to that in the gas replacement step performed before forming the i-type amorphous layer 5c of the first photoelectric conversion layer 5 and the i-type amorphous layer 7c of the second photoelectric conversion layer 7.

### 3-4 (4) Step of forming i-type microcrystalline layer

Next, an i-type microcrystalline layer 9b is formed. The i-type microcrystalline layer 9b can be formed, for example, in the following formation conditions. The substrate temperature is desirably set at a temperature of 200°C or lower. The internal pressure of the film forming chamber 101 during forming the layer is desirably 240 Pa or more and 3600 Pa or less. Further, the power density per unit area of the cathode electrode 102 is desirably set at 0.02 W/cm² or more and 0.5 W/cm² or less.

As a mixture gas introduced into the film forming chamber 101, for example, a gas including a silane gas and a hydrogen gas can be used. A flow rate of the hydrogen gas is desirably 30 times to about several hundreds of times larger than that of the silane gas, and more desirably about 30 times to 300 times.

A thickness of the i-type microcrystalline layer 9b is preferably 0.5 µm or more, and more preferably 1 µm or more in order to secure an adequate amount of light absorption. On the other hand, the thickness of the i-type microcrystalline layer 9b is preferably 20 µm or less, and more preferably 15 µm or less in order to secure a good productivity.

Thus, the i-type microcrystalline layer 9b having a good crystallinity, in which an intensity ratio (I₅₂₀/I₄₈₀) of a peak at 520 nm⁻¹ to a peak at 480 nm⁻¹, measured by Raman spectroscopy, is 3 or more and 10 or less, can be formed.

### 3-4 (5) Step of forming n-type microcrystalline layer

Next, the n-type microcrystalline layer 9c is formed. The n-type microcrystalline layer 9c can be formed, for example, in the following formation conditions. A substrate temperature is desirably set at a temperature of 200°C or lower. The internal pressure of the film forming chamber 101 during forming the layer is desirably 240 Pa or higher and 3600 Pa or less. Further, the power density per unit area of the cathode electrode 102 is desirably set at 0.02 W/cm² or more and 0.5 W/cm² or less.

As a mixture gas introduced into the film forming chamber 101, for example, a gas including a silane gas, a hydrogen gas and a phosphine gas can be used. A flow rate of the hydrogen gas is desirably about several tens of times to several hundreds of times larger than that of the silane gas, and more desirably about 30 times to 300 times.

A thickness of the n-type microcrystalline layer 9c is preferably 2 nm or more in order to provide an adequate internal electric field for the i-type microcrystalline layer 9b. On the other hand, the thickness of the n-type microcrystalline layer 9c is preferably as small as possible in order to suppress the amount of light absorption in the n-type microcrystalline layer 9c being an inactive layer, and it is generally adjusted to 50 nm or less.

### 3-5. Step of forming second electrode

Next, the second electrode 11 is formed on the resulting third photoelectric conversion layer 9. Since the second electrode 11 has a transparent conductive film 11a and the metal film 11b, these films are formed in order.
The transparent conductive film 11a is made of SnO₂ ITO, ZnO or the like. The metal film 11 b is made of metal such as silver, aluminum or the like. The transparent conductive film 11a and the metal film 11b can be formed by methods such as a CVD method, a sputtering method and a vapor deposition method. The transparent conductive film 11a can be omitted.
Thus, the step of producing the photoelectric conversion device of this embodiment is completed. Hereinafter, Examples of the present invention will be described.

### [Example 1]

In Example 1, a stacked photoelectric conversion device 1 having a structure shown in Fig. 1 was produced by use of a plasma CVD apparatus of a multi-chamber system having a plurality of film forming chambers 101 shown in Fig. 2. A film forming chamber of the plasma CVD apparatus used in this Example has an internal size of 1 m×1 m×50 cm. Each component was formed of materials and in thicknesses shown in Table 1. Each of p-type semiconductor layers 5a and 7a and buffer layers 5b and 7b, and i-type semiconductor layers 5c, 7c, and 9c, and n-type semiconductor layers 5d, 7d, and 9c is formed in different film forming chambers 101.

**Table 1**

| Stacked photoelectric conversion device 1 | | |
|---|---|---|
| Name | | Material |
| Substrate 2 | | Glass |
| First electrode 3 | | SnO₂ (projections and depressions of texture structure of surface) |
| First photoelectric conversion layer 5 | P-type amorphous layer 5a | Amorphous silicon carbide |
| | Buffer layer 5b | Amorphous silicon carbide |
| | 1-type amorphous layer 5c | Amorphous silicon |
| | N-type semiconductor layer 5d | Amorphous silicon |
| Second photoelectric conversion layer 7 | P-type amorphous layer 7a | Amorphous silicon carbide |
| | Buffer layer 7b | Amorphous silicon carbide |
| | I-type amorphous layer 7c | Amorphous silicon |
| | N-type semiconductor layer 7d | Amorphous silicon |
| Third photoelectric conversion layer 9 | P-type microcrystalline layer 9a | Microcrystalline silicon |
| | I-type microcrystalline layer 9b | Microcrystalline silicon |
| | N-type microcrystalline layer 9c | Microcrystalline silicon |
| Second electrode 11 | Transparent conductive film 11a | ZnO |
| | Metal film 11b | Ag |

Hereinafter, the respective steps will be described in detail. In this Example, all semiconductor layers were formed by continuous discharge plasma.

### 1. Step of forming first photoelectric conversion layer

### 1-1. Step of forming p-type amorphous layer

First, a p-type amorphous silicon carbide was formed as a p-type amorphous layer 5a on a substrate 2 having a thickness of 4 mm on which a first electrode 3 having a thickness of 1µm was formed. The p-type amorphous layer 5a was formed under conditions of a temperature of the substrate 2 of 200°C, an internal pressure of a film forming chamber 101 of plasma CVD of 500 Pa, a power density per unit area of the cathode electrode of 0.05 W/cm², a mixture gas to be introduced into the film forming chamber 101 composed of an SiH₄ gas/a B₂H₆ gas (diluted with hydrogen so as to have a concentration of 0.1%)/a CH₄ gas of 150 sccm/80 sccm/ 150 sccm, respectively, and a flow rate ratio of an H₂ gas to an SiH₄ gas of 20, and the layer thickness was adjusted to 15 nm.

### 1-2. Step of forming buffer layer

Next, an i-type amorphous silicon carbide was formed as a buffer layer 5b on the p-type amorphous layer 5a. Formation of a film was started under conditions of a temperature of the substrate 2 of 200°C, an internal pressure of the film forming chamber 101 of plasma CVD of 500 Pa, a power density per unit area of the cathode electrode of 0.05 W/cm², a mixture gas to be introduced into the film forming chamber 101 composed of an SiH₄ gas/a CH₄ gas of 150 sccm/150 sccm, respectively, and a flow rate ratio of an H₂ gas to an SiH₄ gas of 10, and the buffer layer 5b was formed while controlling the gas flow rate in such a way that a CH₄ gas flow rate decreases gradually from 150 sccm to 0 sccm to adjust its layer thickness to 10 nm. Here, the CH₄ gas flow rate may be controlled so as to decrease gradually, or so as to decrease stepwise. It is desirable to control the CH₄ gas flow rate so as to decrease gradually or stepwise since by such a control, discontinuity of a band profile at an interface between the p-type amorphous layer 5a and an i-type amorphous layer 5c can be mitigated.

### 1-3. Step of forming i-type amorphous layer

Next, an i-type amorphous silicon layer was formed as the i-type amorphous layer 5c on the buffer layer 5b. The i-type amorphous layer 5c was formed under conditions of a temperature of the substrate 2 of 180°C, an internal pressure of the film forming chamber 101 of plasma CVD of 500 Pa, a power density per unit area of the cathode electrode of 0.07 W/cm², a mixture gas to be introduced into the film forming chamber 101 composed of an SiH₄ gas of 300 sccm and a flow rate ratio of an H₂ gas to an SiH₄ gas of 20, and its layer thickness was adjusted to 100 nm.

### 1-4. Step of forming n-type semiconductor layer

Next, an amorphous silicon layer was formed as an n-type semiconductor layer (here, amorphous layer) 5d on the i-type amorphous layer 5c. The n-type semiconductor layer 5d was formed under conditions of a temperature of the substrate 2 of 200°C, an internal pressure of the film forming chamber 101 of plasma CVD of 500 Pa, a power density per unit area of the cathode electrode of 0.05 W/cm², a mixture gas to be introduced into the film forming chamber 101 composed of an SiH₄ gas/a PH₃ gas (diluted with hydrogen so as to have a concentration of 1%) of 150 sccm/30 sccm, respectively, and a flow rate ratio of an H₂ gas to an SiH₄ gas of 5, and its layer thickness was adjusted to 25 nm.

### 2. Step of forming second photoelectric conversion layer

### 2-1. Step of forming p-type amorphous layer

Next, a p-type amorphous silicon carbide was formed as a p-type amorphous layer 7a of a second photoelectric conversion layer 7 on the n-type semiconductor layer 5d of a first photoelectric conversion layer 5. The formation conditions were identical to those of the p-type amorphous layer 5a of the first photoelectric conversion layer 5.

### 2-2. Step of forming buffer layer

Next, an i-type amorphous silicon carbide was formed as a buffer layer 7b on the p-type amorphous layer 7a. The formation conditions were identical to those of the buffer layer 5b of the first photoelectric conversion layer 5.

### 2-3. Step of forming i-type amorphous layer

Next, an i-type amorphous silicon layer was formed as an i-type amorphous layer 7c on the buffer layer 7b. The i-type amorphous layer 7c was formed under conditions of a temperature of the substrate 2 of 200°C, an internal pressure of the film forming chamber 101 of plasma CVD of 500 Pa, a power density per unit area of the cathode electrode of 0.07 W/cm², a mixture gas to be introduced into the film forming chamber 101 composed of an SiH₄ gas of 300 sccm and a flow rate ratio of an H₂ gas to an SiH₄ gas of 20, and its layer thickness was adjusted to 300nm.
In this Example, a substrate temperature (180°C) during forming the i-type amorphous layer 5c of the first photoelectric conversion layer 5 was made lower than a substrate temperature (200°C) during forming the i-type amorphous layer 7c of the second photoelectric conversion layer 7. Thereby, a concentration of hydrogen atoms contained in the i-type amorphous layer 5c of the first photoelectric conversion layer 5 was made higher than that in the i-type amorphous layer 7c of the second photoelectric conversion layer 7, and the bandgap of the i-type amorphous layer 5c of the first photoelectric conversion layer 5 was made larger than that of the i-type amorphous layer 7c of the second photoelectric conversion layer 7.

### 2-4. Step of forming n-type semiconductor layer

Next, an amorphous silicon layer was formed as an n-type semiconductor layer (here, amorphous layer) 7d on the i-type amorphous layer 7c. The formation conditions were identical to those of the n-type semiconductor layer 5d of the first photoelectric conversion layer 5.

### 3. Step of forming third photoelectric conversion layer

### 3-1. Step of forming p-type microcrystalline layer

Next, a p-type microcrystalline silicon layer was formed as a p-type microcrystalline layer 9a of a third photoelectric conversion layer 9 on the n-type semiconductor layer 7d of the second photoelectric conversion layer 7. The p-type microcrystalline layer 9a was formed under conditions of a temperature of the substrate 2 of 200°C, an internal pressure of the film forming chamber 101 of plasma CVD of 1000 Pa, a power density per unit area of the cathode electrode of 0.15 W/cm², a mixture gas to be introduced into the film forming chamber 101 composed of an SiH₄ gas/a B₂H₆ gas (diluted with hydrogen so as to have a concentration of 0.1%) of 150 sccm/30 sccm, respectively, and a flow rate ratio of an H₂ gas to an SiH₄ gas of 150, and its layer thickness was adjusted to 40 nm.

### 3-2. Step of forming i-type microcrystalline layer

Next, an i-type microcrystalline silicon layer was formed as an i-type microcrystalline layer 9b on the p-type microcrystalline layer 9a. The i-type microcrystalline layer 9b was formed under conditions of a temperature of the substrate 2 of 200°C, an internal pressure of the film forming chamber 101 of plasma CVD of 2000 Pa, a power density per unit area of the cathode electrode of 0.15 W/cm², a mixture gas to be introduced into the film forming chamber 101 composed of an SiH₄ gas of 250 sccm and a flow rate ratio of an H₂ gas to an SiH₄ gas of 100, and its layer thickness was adjusted to 2.5 µm.

### 3-3. Step of forming n-type microcrystalline layer

Next, an n-type microcrystalline silicon layer was formed as an n-type microcrystalline layer 9d on the i-type microcrystalline layer 9b. The n-type microcrystalline layer 9d was formed under conditions of a temperature of the substrate 2 of 200°C, an internal pressure of the film forming chamber 101 of plasma CVD of 2000 Pa, a power density per unit area of the cathode electrode of 0.15 W/cm², a mixture gas to be introduced into the film forming chamber 101 composed of an SiH₄ gas/a PH₃ gas (diluted with hydrogen so as to have a concentration of 1%) of 150 sccm/30 sccm, respectively, and a flow rate ratio of an H₂ gas to an SiH₄ gas of 150, and its layer thickness was adjusted to 40 nm.

### 4. Step of forming second electrode

Next, a second electrode 11 made of a transparent conductive film 11a having a thickness of 0.05 µm and a metal film 11b having a thickness of 0.1 µm is formed by a sputtering method to produce a stacked photoelectric conversion device.

### 5. Performance evaluation

When a current-voltage characteristic photoelectric conversion efficiency of the obtained stacked photoelectric conversion device with a light-receiving area of 1 cm² was measured under the irradiation condition of AM 1.5 (100 mW/cm²), stabilized photoelectric conversion efficiency after light degradation was 12.7%. The device performance after light degradation means performance exhibited after the device is irradiated at 25°C for 1000 hours under the irradiation condition of AM 1.5 (100 mW/cm²).

### 6. Associated experiment

In the above-mentioned Example, by using a substrate temperature (180°C) during forming the i-type amorphous layer 5c lower than a substrate temperature (200°C) during forming the i-type amorphous layer 7c, the bandgap of the i-type amorphous layer 5c was made larger than the bandgap of the i-type amorphous layer 7c, but as a method of controlling the bandgaps of the i-type amorphous layers 5c and 7c, there are also a method of controlling the flow rate ratio of an H₂ gas to an SiH₄ gas in forming the i-type amorphous layer and a method of switching between continuous discharge plasma and pulse discharge plasma to form the i-type amorphous layer. In this associated experiment, it will be shown that the bandgap can be controlled by these methods.

In this associated experiment were measured the concentrations of hydrogen atoms contained in the i-type amorphous layer and the relative values of long-wavelength sensitivity of a p-i-n type photoelectric conversion device having the i-type amorphous layer above as an i-layer, in the case where an SiH₄ gas flow rate in forming the i-type amorphous layer was kept constant at 150 sccm and the flow rate ratio of an H₂ gas to an SiH₄ gas was changed by changing an H₂ gas flow rate. The results of measurement are shown in Table 2. The results of measurement in forming the i-type amorphous layer by continuous discharge plasma are shown in Table 2 together with the results of measurement in forming the i-type amorphous layer by pulse discharge plasma.

Here, the concentration of hydrogen atoms is the result of measuring the i-type amorphous layer monolayer film (film thickness is 300 nm) deposited on a silicon wafer by infrared emission spectrometry (FT-IR). The relative value of long-wavelength sensitivity is determined by measuring spectral sensitivity on a p-i-n type photoelectric conversion layer (film thickness of an i-layer is 300 nm) having the i-type amorphous layer as an i-layer, and normalizing an integration value of EQE (external quantum efficiency) in a wavelength range of 550 to 800 nm.

In addition, the p-i-n type photoelectric conversion device was formed according to the method of forming the first photoelectric conversion layer 5. However, as the flow rate ratio of the H₂ gas to SiH₄ gas in forming the i-type amorphous layer, values in Table 2 were used. In addition, a voltage waveform applied to the cathode electrode for generating plasma of pulse discharge plasma was set in such a way that an average of a power density per unit area of the cathode electrode is equal to that in continuous discharge plasma setting a duty ratio at 20% and a pulse width of on/off at 0.5 ms/2.0 ms.

**Table 2**

| Flow rate ratio of H₂ gas to SiH₄ gas | Continuous discharge plasma | | Pulse Discharge plasma | |
|---|---|---|---|---|
| | Conc. of hydrogen (atomic %) | Relative value of long-wavelength sensitivity | Conc. of hydrogen (atomic %) | Relative value of long-wavelength sensitivity |
| 5 | 7.3 | 0.96 | 4.0 | 1 |
| 10 | 9.4057 | 0.92 | 6.5 | 0.98 |
| 20 | 12.814 | 0.87 | 10.2 | 0.9 |
| 30 | 14.774 | 0.83 | - | - |
| 50 | 15.8 | 0.8 | - | - |

| | | | | |
|---|---|---|---|---|
| conc. = concentration | | | | |

Table 2 shows that when the flow rate ratio of the H₂ gas to SiH₄ gas is increased, a concentration of hydrogen atoms contained in the i-type amorphous layer becomes higher and a relative value of long-wavelength sensitivity becomes smaller. The reduction in the relative value of long wavelength sensitivity indicates that the bandgap of the i-type amorphous layer becomes larger. Also, Table 2 shows that the bandgap of the i-type amorphous layer can be controlled by controlling the flow rate ratio of the H₂ gas to SiH₄ gas.

Table 2 shows that a concentration of hydrogen introduced into the i-type amorphous layer in forming the i-type amorphous layer by continuous discharge plasma is higher than that in forming the i-type amorphous layer by pulse discharge plasma in the comparison at the same flow rate ratio of the H₂ gas to SiH₄ gas in forming the i-type amorphous layer. This result indicates that the bandgap of the i-type amorphous layer can be controlled by selecting either continuous discharge plasma or pulse discharge plasma. Also, Table 2 suggests that in the case of pulse discharge plasma, the bandgap of the i-type amorphous layer can be controlled by controlling a duty ratio of a pulse. For example, when the i-type amorphous layer 5c of a first photoelectric conversion layer 5 and the i-type amorphous layer 7c of a second photoelectric conversion layer 7 are formed by pulse discharge plasma, the duty ratio of the pulse can be made higher in the formation of the i-type amorphous layer 5c than that of the i-type amorphous layer 7c. In this case, the bandgap of the i-type amorphous layer 5c can be made larger than the bandgap of the i-type amorphous layer 7c.

Further, it is evident that the bandgap of the i-type amorphous layer can be controlled in a larger range when adjustment of the flow rate ratio of the H₂ gas to SiH₄ gas is used in conjunction with switching between continuous discharge plasma and pulse discharge plasma

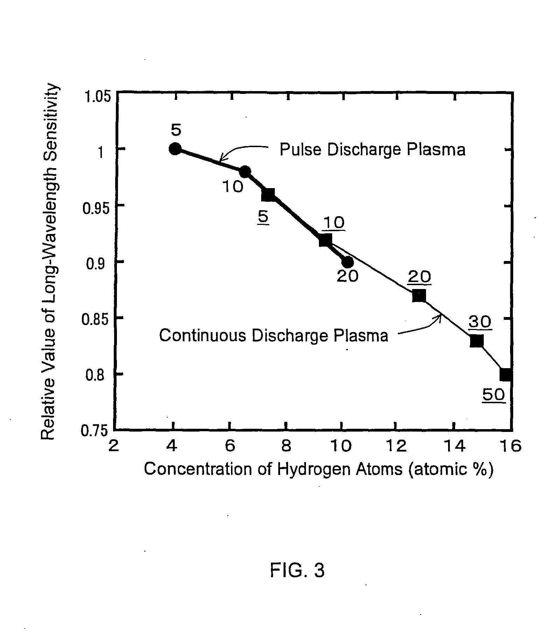

Fig. 3 is a graph on which the concentrations of hydrogen atoms and relative values of long wavelength sensitivity in Table 2 are plotted. Numerical values in Fig. 3 indicate the flow rate ratios of gases. Numerical values related to the continuous discharge plasma are underlined.
Fig. 3 shows that a relative value of long wavelength sensitivity of a photoelectric conversion device having the i-type amorphous layer formed by pulse discharge plasma is larger than that of a photoelectric conversion device having the i-type amorphous layer formed by continuous discharge plasma. This fact means that the i-type amorphous layer formed by continuous discharge plasma is suitable for the i-type amorphous layer 5c of the first photoelectric conversion layer 5 and the i-type amorphous layer formed by pulse discharge plasma is suitable for the i-type amorphous layer 7c of the second photoelectric conversion layer 7.

### [Example 2]

In Example 2, substrate temperatures during forming the i-type amorphous layer 5c of the first photoelectric conversion layer 5 and the i-type amorphous layer 7c of the second photoelectric conversion layer 7 in Example 1 were both set to 200°C.
In this Example, in consideration of the results of the above-mentioned associated experiment, the i-type amorphous layer 5c of the first photoelectric conversion layer 5, located on the light entrance side, was formed by continuous discharge plasma and the i-type amorphous layer 7c of the second photoelectric conversion layer 7 was formed by pulse discharge plasma

Specifically, in forming the i-type amorphous layer 5c of the first photoelectric conversion layer 5, alternating electric power of 13.56 MHz was applied to the cathode electrode, and in forming the i-type amorphous layer 7c of the second photoelectric conversion layer 7, alternating electric power formed by pulse-modulating alternating electric power of 13.56 MHz was applied to the cathode electrode. A voltage waveform applied to the cathode electrode for generating plasma of pulse discharge plasma was set in such a way that an average of a power density per unit area of the cathode electrode is equal to that in Example 1 setting a duty ratio at 50% and a pulse width of on/off at 1 ms/1ms.

Further, a flow rate ratio of an H₂ gas to an SiH₄ gas in forming the i-type amorphous layer 5c of the first photoelectric conversion layer 5 was set at 50 and the flow rate ratio of the H₂ gas to the SiH₄ gas in forming the i-type amorphous layer 7c of the second photoelectric conversion layer 7 was set at 5.

Other formation conditions were identical to those in Example 1. A current-voltage characteristic photoelectric conversion efficiency of the stacked photoelectric conversion device with a light-receiving area of 1 cm², obtained in this Example, was measured under the irradiation condition of AM 1.5 (100 mW/cm²), and consequently stabilized photoelectric conversion efficiency after light degradation was 12.7%, and the photoelectric conversion characteristic comparable to that in Example 1 could be attained.

### [Example 3]

In Example 3, a stacked photoelectric conversion device 1 having a structure identical to Example 1 was produced by use of the plasma CVD apparatus of a single chamber having one film forming chamber 101 illustrated in Fig. 2. The first photoelectric conversion layer 5, the second photoelectric conversion layer 7 and the third photoelectric conversion layers 9 are successively formed without opening to the air by use of the same electrode in the same film forming chamber. Further, a substrate temperature was set at 200°C, and the first, the second and the third photoelectric conversion layers 5, 7, and 9 all were formed at the same temperature. Other formation conditions of the first, the second and the third photoelectric conversion layers 5, 7, and 9 were identical to those of Example 1.

Further, the gas replacement step was performed before forming the first photoelectric conversion layer 5, the i-type amorphous layer 5c of the first photoelectric conversion 5, the second photoelectric conversion layer 7, the i-type amorphous layer 7c of the second photoelectric conversion layer 7, the third photoelectric conversion layer 9, and the i-type microcrystalline layer 9b of the third photoelectric conversion layer 9.

Each gas replacement step was performed by following the procedure below. First, the inside of the film forming chamber 101 is evacuated with a vacuum pump until the internal pressure of the film forming chamber 101 reaches 0.5 Pa. Next, a hydrogen gas is introduced into the film forming chamber 101 as a replacement gas (step of introducing a replacement gas), and the introduction of the hydrogen gas is stopped when the internal pressure of the film forming chamber 101 reaches 100 Pa, and then the hydrogen gas is evacuated with the vacuum pump until the internal pressure of the film forming chamber 101 reaches 10 Pa (evacuation step). Gas replacement was performed by repeating this cycle including the step of introducing a replacement gas and the evacuation step four times.

A current-voltage characteristic photoelectric conversion efficiency of the stacked photoelectric conversion device with a light-receiving area of 1 cm², obtained in this Example, was measured under the irradiation condition of AM 1.5 (100 mW/cm²), and consequently stabilized photoelectric conversion efficiency after light degradation was 12.6%, and the photoelectric conversion characteristic comparable to those in Examples 1 and 2 could be attained.

## Claims

1. A stacked photoelectric conversion device comprising a first photoelectric conversion layer, a second photoelectric conversion layer and a third photoelectric conversion layer each having a p-i-n junction and made of a silicon base semiconductor, stacked in this order from a light entrance side, wherein the first and the second photoelectric conversion layers have an i-type amorphous layer made of an amorphous silicon base semiconductor, respectively, and the third photoelectric conversion layer has an i-type microcrystalline layer made of a microcrystalline silicon base semiconductor.

2. The device of claim 1, wherein a bandgap of the i-type amorphous layer of the first photoelectric conversion layer is larger than that of the i-type amorphous layer of the second photoelectric conversion layer.

3. The device of claim 1 or 2, wherein a concentration of hydrogen atoms in the i-type amorphous layer of the first photoelectric conversion layer is higher than that in the i-type amorphous layer of the second photoelectric conversion layer.

4. A method of producing a stacked photoelectric conversion device comprising the step of forming a first photoelectric conversion layer, a second photoelectric conversion layer and a third photoelectric conversion layer each having a p-i-n junction and made of a silicon base semiconductor, stacked in this order from a light entrance side, wherein the first and the second photoelectric conversion layers are formed so as to have an i-type amorphous layer made of an amorphous silicon base semiconductor, respectively, and the third photoelectric conversion layer is formed so as to have an i-type microcrystalline layer made of a microcrystalline silicon base semiconductor.

5. The method of claim 4, wherein the first photoelectric conversion layer and the second photoelectric conversion layer are formed in such a way that a bandgap of the i-type amorphous layer of the first photoelectric conversion layer is larger than that of the i-type amorphous layer of the second photoelectric conversion layer.

6. The method of claim 4 or 5, wherein the first, the second and the third photoelectric conversion layers are formed by a plasma CVD method using a process gas including an H₂ gas and an SiH₄ gas, and
the first and the second photoelectric conversion layers are formed in such a way that a flow rate ratio of the H₂ gas to the SiH₄ gas in forming the i-type amorphous layer of the first photoelectric conversion layer is larger than a flow rate ratio of the H₂ gas to the SiH₄ gas in forming the i-type amorphous layer of the second photoelectric conversion layer.

7. The method of any one of claims 4 to 6, wherein the first, the second and the third photoelectric conversion layers is formed by a plasma CVD method using a process gas including an H₂ gas and an SiH₄ gas, and the i-type amorphous layer of the first photoelectric conversion layer is formed by continuous discharge plasma and the i-type amorphous layer of the second photoelectric conversion layer is formed by pulse discharge plasma.

8. The method of any one of claims 4 to 7, wherein the i-type amorphous layers of the first and the second photoelectric conversion layers are formed at the same substrate temperature.

9. The method of any one of claims 4 to 8, wherein the first, the second and the third photoelectric conversion layers are formed in succession in the same film forming chamber,
further comprising the gas replacement steps of replacing an inside of the film forming chamber with a replacement gas before forming the first, the second and the third photoelectric conversion layers, the i-type amorphous layers of the first and the second photoelectric conversion layers, and the i-type microcrystalline layer of the third photoelectric conversion layer, respectively.
